(19) Europäisches Patentamt
European Patent Office
Office européen des brevets

(11) **EP 4 764 700 A1**

(12) **EUROPEAN PATENT APPLICATION**

(43) Date of publication:
**24.06.2026 Bulletin 2026/26**

(21) Application number: **24221971.5**

(22) Date of filing: **19.12.2024**

(51) International Patent Classification (IPC):
**G03F 7/00** (2006.01)    **G02B 6/12** (2006.01)

(52) Cooperative Patent Classification (CPC):
**G03F 7/706849; G02B 6/12; G03F 7/706851**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH MA MD TN**

(71) Applicants:
• **ASML Netherlands B.V.**
**5500 AH Veldhoven (NL)**
• **Technische Universiteit Eindhoven**
**5612 AE Eindhoven (NL)**

(72) Inventors:
• **SETIJA, Irwan, Dani**
**5500 AH Veldhoven (NL)**
• **LIU, Tianran**
**5500 AH Veldhoven (NL)**
• **DE VOCHT, David, Johan, Y.**
**5500 AH Veldhoven (NL)**
• **JIAO, Yuqing**
**5500 AH Veldhoven (NL)**
• **BENTE, Erwin, Antonius, Josephus, Maria**
**5500 AH Veldhoven (NL)**

(74) Representative: **ASML Netherlands B.V.**
**Corporate Intellectual Property**
**P.O. Box 324**
**5500 AH Veldhoven (NL)**

(54) **METROLOGY TOOL AND COMPONENTS THEREFOR**

(57) An optical coupler for a photonic integrated circuit comprising a first channel waveguide configured to guide electromagnetic radiation comprising a first wavelength. The optical coupler comprises a second channel waveguide configured to guide electromagnetic radiation comprising a second wavelength that is different to the first wavelength. The optical coupler comprises a slab waveguide optically coupled to the first and second channel waveguides and configured to guide electromagnetic radiation comprising both the first and second wavelengths. The optical coupler comprises a computer generated waveguide hologram optically coupled to the slab waveguide. The optical coupler comprises a metasurface optically coupled to the computer generated waveguide hologram.

FIG. 5

**Description**

FIELD

The present invention relates to a new metrology apparatus or metrology tool.

BACKGROUND

A lithographic apparatus is a machine constructed to apply a desired pattern onto a substrate. A lithographic apparatus can be used, for example, in the manufacture of integrated circuits (ICs). A lithographic apparatus may, for example, project a pattern (also often referred to as "design layout" or "design") at a patterning device (e.g., a mask) onto a layer of radiation-sensitive material (resist) provided on a substrate (e.g., a wafer).

To project a pattern on a substrate a lithographic apparatus may use electromagnetic radiation. The wavelength of this radiation determines the minimum size of features which can be formed on the substrate. Typical wavelengths currently in use are 365 nm (i-line), 248 nm, 193 nm and 13.5 nm. A lithographic apparatus, which uses extreme ultraviolet (EUV) radiation, having a wavelength within the range 4-20 nm, for example 6.7 nm or 13.5 nm, may be used to form smaller features on a substrate than a lithographic apparatus which uses, for example, radiation with a wavelength of 193 nm.

As electronic circuit features are becoming smaller and tolerances for errors such as overlay errors are becoming tighter, the alignment of a semiconductor substrate relative to a lithographic patterning device (i.e. a mask) becomes critical to manufacturing electronic integrated circuits. However, when a substrate is clamped on the wafer stage of a lithographic apparatus, the substrate warps. Substrate warping may occur for other reasons such as, for example, during substrate processing. The surface lines of a warped substrate follow a nonlinear curved trajectory. So, aligning the substrate at a single point does not suffice to align the substrate with respect to a patterning device. Aligning the substrate at multiple different locations overcomes this problem at the cost of a throughput penalty of the lithography process.

It may be desirable to provide a new optical metrology system and method, and components therefor, for determining one or more parameters of a target mark (e.g. a periodic alignment pattern formed on a substrate) that at least partially addresses one or more problems associated with known arrangements, whether such problems are identified herein or otherwise.

SUMMARY

According to a first aspect of the present disclosure there is provided an optical coupler for a photonic integrated circuit. The optical coupler comprises a first channel waveguide configured to guide electromagnetic radiation comprising a first wavelength. The optical coupler comprises a second channel waveguide configured to guide electromagnetic radiation comprising a second wavelength that is different to the first wavelength. The optical coupler comprises a slab waveguide optically coupled to the first and second channel waveguides and configured to guide electromagnetic radiation comprising both the first and second wavelengths. The optical coupler comprises a computer generated waveguide hologram optically coupled to the slab waveguide. The optical coupler comprises a metasurface optically coupled to the computer generated waveguide hologram.

The first wavelength may form part of a first bandwidth. The first wavelength may be a central wavelength of the first bandwidth. The second wavelength may form part of a second bandwidth. The second wavelength may be a central wavelength of the second bandwidth. The first and second bandwidths may be different. The first and second bandwidths may not overlap. The first and second wavelengths may be selected from the range of about 500 nm to about 1600 nm.

The optical coupler may be configured to act as an emitter. The optical coupler may be configured to act as a receiver. The optical coupler may be configured to act as a transceiver. That is, the optical coupler may be configured to act as both an emitter and a receiver.

The optical coupler may be formed on a SiN-based platform. The optical coupler may be formed on an InP-based platform. The optical coupler may be formed on an InP Membrane On-Silicon (IMOS) platform. The optical coupler may be formed on a Silicon-On-Insulator (SOI) platform.

The optical coupler may be substantially planar. The optical coupler may comprise two layers. A first layer may comprise the first and second channel waveguides, the slab waveguide and the computer generated waveguide hologram. A second layer may comprise the metasurface.

When the optical coupler acts as an emitter, the slab waveguide may be configured to allow spatial expansion of the electromagnetic radiation received from the first channel waveguide and/or the second channel waveguide. When the optical coupler acts as a receiver, the slab waveguide may be configured to allow spatial contraction of the electromagnetic radiation received from the computer generated waveguide hologram. It will be appreciated that the optical coupler can act as both an emitter and a receiver depending on the location of a source of the electromagnetic radiation.

At least one of the first channel waveguide and the second channel waveguide may comprise an adiabatic waveguide taper that is optically coupled to the slab waveguide.

When the optical coupler acts as an emitter, the adiabatic waveguide taper may be configured to spatially expand the electromagnetic radiation received from the first channel waveguide and/or the second channel waveguide. The slab waveguide may be configured such that the spatial expansion of the electromagnetic radiation continues as the electromagnetic radiation propagates through the slab waveguide to the computer generated waveguide hologram. When the optical coupler acts as a receiver, the adiabatic waveguide taper may be configured to spatially contract the electromagnetic radiation received from the slab waveguide.

The computer generated waveguide hologram (CGWH) may comprise an arrangement of unit cells. Each unit cell may comprise a structure configured to introduce a phase shift to incident electromagnetic radiation. A distance between the structures of two neighboring unit cells may vary across at least part of the arrangement of unit cells. This arrangement advantageously adjusts a phase profile of incident electromagnetic radiation.

Local period is the distance between structures that occupy neighboring unit cells may be referred to as the local period. The local period may vary across the CGWH.

The arrangement of unit cells may comprise a two dimensional array of unit cells.

The unit cells may take the form of a rectangular prism.

The unit cells may comprise one or more subwavelength dimensions.

The structures may comprise one or more subwavelength dimensions.

The structures may comprise nanostructures.

The structures may take the form of a rectangular prism. For example, the structures may comprise a rectangular column or a rectangular well.

The structures may be etched into the slab waveguide. The structures may be deposited on the slab waveguide.

A layer having a lower refractive index than the slab waveguide may be provided on the slab waveguide. The structures may be etched into the lower refractive index layer. The structures may correspond to a region of the lower refractive index layer that has been etched away to reveal a portion of the underlying slab waveguide. The lower refractive index layer may comprise SiN. The slab waveguide may comprise InP.

A size of the structure within each unit cell may vary across at least part of the arrangement of unit cells. This arrangement advantageously adjusts an intensity profile of incident electromagnetic radiation.

The in-plane area of a structure relative to the in-plane area of the unit cell the structure occupies may be referred to as a filling ratio. The filling ratio may vary across the CGWH.

Known CGWHs are typically designed to achieve a desired phase profile of an emitted beam. That is, in known CGWHs, the structure positions are optimized, but the filling ratio across known CGWHs is kept constant. By varying the filling ratios, the structures may provide stronger scattering whilst simultaneously ensuring a uniform intensity profile of the emitted beam.

The arrangement of unit cells may have a first pitch in a first direction and a second pitch in a second direction. The first pitch may correspond to a first dimension of a unit cell and the second pitch may correspond to a second dimension of a unit cell that is orthogonal to the first dimension. The first and second dimensions of a unit cell may correspond to an in-plane area of the unit cell. The first dimension of the unit cell may be substantially parallel to a length of the optical coupler. The second dimension of the unit cell may be parallel to a width of the optical coupler.

The first and second pitches may be different. The first pitch may be greater than the second pitch. The first pitch may be similar to or greater than a shortest wavelength that the optical coupler is configured to couple. The second pitch may be less than a shortest wavelength that the optical coupler is configured to couple. That is, the second pitch may be subwavelength. The guided mode may therefore only experience scattering and diffraction phenomena in the first direction.

A structure may have a first dimension that is parallel to the first dimension of its corresponding unit cell and a second dimension that is parallel to the second dimension of its corresponding unit cell. The first and second dimensions may be different. The first and second dimensions of a structure may correspond to an in-plane area of the structure.

The sizes of the structures may at least partially determine an emission pattern of the CGWH. For example, when the optical coupler acts as an emitter, the first and/or second dimensions of the structures may be selected to achieve a desired intensity profile (e.g. a Gaussian intensity profile) in the far field.

A center of a structure may be offset from a center of the unit cell that the structure occupies in the first direction. The offset of the structures in the first direction may vary across at least part of the arrangement of unit cells. When the optical coupler acts as an emitter, the offsets of the structures in the first direction may be selected such that out-coupled electromagnetic radiation interferes constructively at a desired location in free space.

The structures are computer-designed. The structures may be fabricated at least in part using lithography. The structures may be fabricated at least in part using wafer-scale semiconductor manufacturing techniques.

An electromagnetic field solver method may be used to simulate the effects of and/or design the CGWH. For example, Finite-Difference Time Domain (FDTD) modelling may be used to simulate the effects of and/or design the CGWH.

The metasurface may comprise an arrangement of metasurface structures configured to introduce a phase shift to incident electromagnetic radiation. A form of the metasurface structures may vary across at least part of the arrangement of metasurface structures. This arrangement advantageously reduces or avoids the generation of undesired "ghost" beams of electromagnetic radiation that would otherwise be generated by the CGWH, thereby improving an optical efficiency of the optical coupler.

The local phase shift applied to the electromagnetic radiation by a metasurface structure may depend upon the form of the metasurface structure. The form of the metasurface structure may comprise a size of the metasurface structure. The form of the metasurface structure may comprise a shape of the metasurface structure.

An electromagnetic field solver method may be used to simulate the effects of and/or design the metasurface. For example, Finite-Difference Time Domain (FDTD) modelling may be used to simulate the effects of and/or design the metasurface and the metasurface structures.

When the optical coupler acts as an emitter, the form of the metasurface structures may vary across at least part of the arrangement of metasurface structures such that a first beam of electromagnetic radiation comprising the first wavelength and a second beam of electromagnetic radiation comprising the second wavelength having different angles of incidence are focused to substantially the same focal point in free space. When the optical coupler acts as a receiver, the form of the metasurface structures may vary across at least part of the arrangement of metasurface structures such that a beam electromagnetic radiation comprising both the first and second wavelengths is separated into a first beam comprising the first wavelength and a second beam comprising the second wavelength in different propagation directions.

The metasurface structures may comprise pillars. The pillars may be nanopillars.

According to another aspect of the present disclosure, there is provided an optical coupler for a photonic integrated circuit. The optical coupler comprises a first region configured to couple a first wavelength of electromagnetic radiation. The optical coupler comprises a second region configured to couple a second wavelength of electromagnetic radiation that is different to the first wavelength of electromagnetic radiation. The optical coupler comprises an intermediate region located between the first and second regions and configured to couple both the first and second wavelengths of electromagnetic radiation.

The intermediate region advantageously allows overlapping diffraction orders comprising different wavelengths to be coupled into a photonic integrated circuit. This may be particularly useful in performing lithographic alignment measurements.

The first wavelength may form part of a first bandwidth. The first wavelength may be a central wavelength of the first bandwidth. The second wavelength may form part of a second bandwidth. The second wavelength may be a central wavelength of the second bandwidth. The first and second bandwidths may be different. The first and second bandwidths may not overlap. The first and second wavelengths may be selected from the range of about 500 nm to about 1600 nm.

The optical coupler may be configured to act as an emitter. The optical coupler may be configured to act as a receiver. The optical coupler may be configured to act as a transceiver. That is, the optical coupler may be configured to act as both an emitter and a receiver.

The optical coupler may be formed on a SiN-based platform. The optical coupler may be formed on an InP-based platform. The optical coupler may be formed on an InP Membrane On-Silicon (IMOS) platform. The optical coupler may be formed on a Silicon-On-Insulator (SOI) platform.

The optical coupler may be substantially planar.

The first region may comprise a first computer generated waveguide hologram. The second region may comprise a second computer generated waveguide hologram. The intermediate region may comprise both the first and second computer generated waveguide holograms.

According to another aspect of the present disclosure, there is provided a photonic integrated circuit. The photonic integrated circuit comprises a first optical coupler in accordance with one of the abovementioned aspects and a second optical coupler in accordance with the other of the abovementioned aspects.

The photonic integrated circuit may be monolithic.

According to another aspect of the present disclosure, there is provided an optical metrology system comprising the photonic integrated circuit of the abovementioned aspect.

The first optical coupler may be configured to emit electromagnetic radiation comprising the first and second wavelengths at a target mark. The second optical coupler may be configured to receive diffracted electromagnetic radiation from the target mark.

The optical metrology system may comprise a plurality photonic integrated circuits in accordance with the abovementioned aspect. At least two of the photonic integrated circuits may be configured to simultaneously emit electromagnetic radiation to, and receive diffracted electromagnetic radiation from, two separated target marks. This arrangement advantageously allows simultaneous alignment measurements of the substrate at multiple different locations thereby at least partially accounting for the problem of wafer warpage without incurring the throughput penalty that is associated with known systems that are limited to single substrate location measurements.

According to another aspect of the present disclosure, there is provided a lithographic apparatus comprising the optical metrology system of any preceding aspect.

According to another aspect of the present disclosure, there is provided a method of optically measuring a target mark. The method comprises using the optical coupler of the first aspect to emit electromagnetic radiation comprising the first and second wavelengths at the target mark. The method comprises using the optical coupler of the second aspect to receive diffracted electromagnetic radiation from the target mark.

According to another aspect of the present disclosure, there is provided a method of optically measuring first and second separated target marks. The method comprises using a first photonic integrated circuit in accordance with the previous aspect to optically measure the first target mark. The method comprises using a second photonic integrated circuit in accordance with the previous aspect to optically measure the second target mark. The first optical coupler of the first and second photonic integrated circuits is configured to emit electromagnetic radiation comprising the first and second wavelengths at the first and second target marks. The second optical coupler of the first and second photonic integrated circuits is configured to receive diffracted electromagnetic radiation from the first and second target marks.

Any of the features of any of the abovementioned aspects may be combined in any way.

BRIEF DESCRIPTION OF THE DRAWINGS

Embodiments will now be described, by way of example only, with reference to the accompanying schematic drawings, in which:

Figure 1 depicts a schematic overview of a lithographic apparatus;

Figure 2 depicts a schematic overview of a lithographic cell;

Figure 3 depicts a schematic representation of holistic lithography, representing a cooperation between three key technologies to optimize semiconductor manufacturing;

Figure 4 schematically depicts a known alignment sensor;

Figure 5 schematically depicts a first optical coupler for a photonic integrated circuit in accordance with the present disclosure;

Figure 6 schematically depicts the first optical coupler of Fig. 5 with the second layer comprising the metasurface no longer present, thereby revealing the computer generated waveguide hologram in greater detail;

Figure 7 schematically depicts an optical coupler formed on a SiN-based platform in accordance with the present disclosure;

Figure 8 schematically depicts a metasurface in accordance with the present disclosure.

Figure 9 schematically depicts an alternative optical coupler in accordance with the present disclosure;

Figure 10 schematically depicts a photonic integrated circuit in accordance with the present disclosure;

Figure 11 schematically depicts an optical metrology system in accordance with the present disclosure.

DETAILED DESCRIPTION

In the present document, the terms "radiation" and "beam" are used to encompass all types of electromagnetic radiation, including ultraviolet radiation (e.g. with a wavelength of 365, 248, 193, 157 or 126 nm) and EUV (extreme ultra-violet radiation, e.g. having a wavelength in the range of about 5-100 nm).

The term "reticle", "mask" or "patterning device" as employed in this text may be broadly interpreted as referring to a generic patterning device that can be used to endow an incoming radiation beam with a patterned cross-section, corresponding to a pattern that is to be created in a target portion of the substrate. The term "light valve" can also be used in this context. Besides the classic mask (transmissive or reflective, binary, phase-shifting, hybrid, etc.), examples of other such patterning devices include a programmable mirror array and a programmable LCD array.

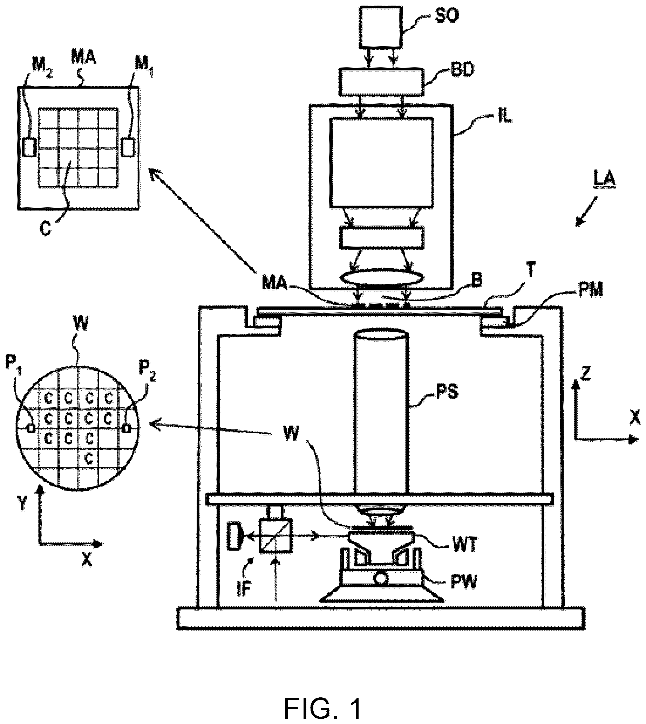

Figure 1 schematically depicts a lithographic apparatus LA. The lithographic apparatus LA includes an illumination system (also referred to as illuminator) IL configured to condition a radiation beam B (e.g., UV radiation, DUV radiation or EUV radiation), a mask support (e.g., a mask table) MT constructed to support a patterning device (e.g., a mask) MA and connected to a first positioner PM configured to accurately position the patterning device MA in accordance with certain parameters, a substrate support (e.g., a wafer table) WT constructed to hold a substrate (e.g., a resist coated wafer) W and connected to a second positioner PW configured to accurately position the substrate support in accordance with certain parameters, and a projection system (e.g., a refractive projection lens system) PS configured to project a pattern imparted to the radiation beam B by patterning device MA onto a target portion C (e.g., comprising one or more dies) of the substrate W.

In operation, the illumination system IL receives a radiation beam from a radiation source SO, e.g. via a beam delivery system BD. The illumination system IL may include various types of optical components, such as refractive, reflective, magnetic, electromagnetic, electrostatic, and/or other types of optical components, or any combination thereof, for directing, shaping, and/or controlling radiation. The illuminator IL may be used to condition the radiation beam B to have a desired spatial and angular intensity distribution in its cross section at a plane of the patterning device MA.

The term "projection system" PS used herein should be broadly interpreted as encompassing various types of projection system, including refractive, reflective, catadioptric, anamorphic, magnetic, electromagnetic and/or electrostatic optical systems, or any combination thereof, as appropriate for the exposure radiation being used, and/or for other factors such as the use of an immersion liquid or the use of a vacuum. Any use of the term "projection lens" herein may be considered as synonymous with the more general term "projection system" PS.

The lithographic apparatus LA may be of a type wherein at least a portion of the substrate may be covered by a liquid having a relatively high refractive index, e.g., water, so as to fill a space between the projection system PS and the substrate W - which is also referred to as immersion lithography.

The lithographic apparatus LA may also be of a type having two or more substrate supports WT (also named "dual stage"). In such "multiple stage" machine, the substrate supports WT may be used in parallel, and/or steps in preparation of a subsequent exposure of the substrate W may be carried out on the substrate W located on one of the substrate support WT while another substrate W on the other substrate support WT is being used for exposing a pattern on the other substrate W.

In addition to the substrate support WT, the lithographic apparatus LA may comprise a measurement stage. The measurement stage is arranged to hold a sensor and/or a cleaning device. The sensor may be arranged to measure a property of the projection system PS or a property of the radiation beam B. The measurement stage may hold multiple sensors. The cleaning device may be arranged to clean part of the lithographic apparatus, for example a part of the projection system PS or a part of a system that provides the immersion liquid. The measurement stage may move beneath the projection system PS when the substrate support WT is away from the projection system PS.

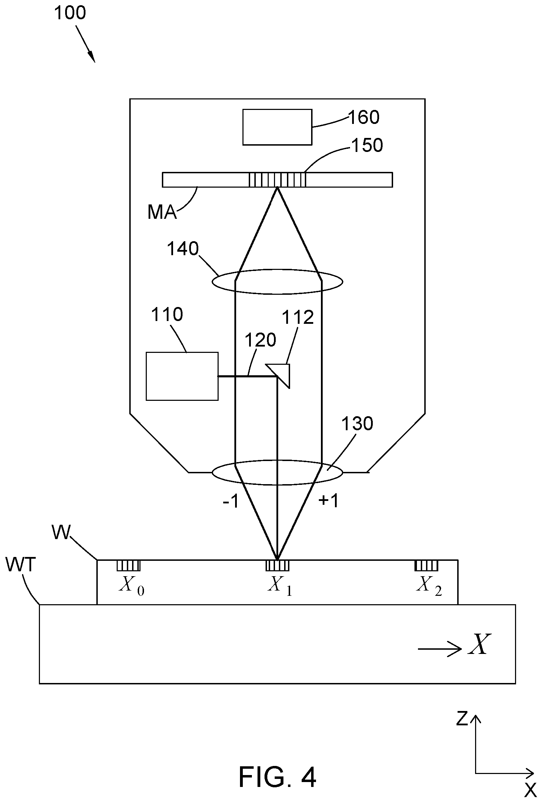

In operation, the radiation beam B is incident on the patterning device, e.g. mask, MA which is held on the mask support MT, and is patterned by the pattern (design layout) present on patterning device MA. Having traversed the mask MA, the radiation beam B passes through the projection system PS, which focuses the beam onto a target portion C of the substrate W. With the aid of the second positioner PW and a position measurement system IF, the substrate support WT can be moved accurately, e.g., so as to position different target portions C in the path of the radiation beam B at a focused and aligned position. Similarly, the first positioner PM and possibly another position sensor (which is not explicitly depicted in Figure 1) may be used to accurately position the patterning device MA with respect to the path of the radiation beam B. Patterning device MA and substrate W may be aligned using mask alignment marks M1, M2 and substrate alignment marks P1, P2 (e.g. using the known alignment sensor 100 of Fig. 4). Although the substrate alignment marks P1, P2 as illustrated occupy dedicated target portions, they may be located in spaces between target portions. Substrate alignment marks P1, P2 are known as scribe-lane alignment marks when these are located between the target portions C.

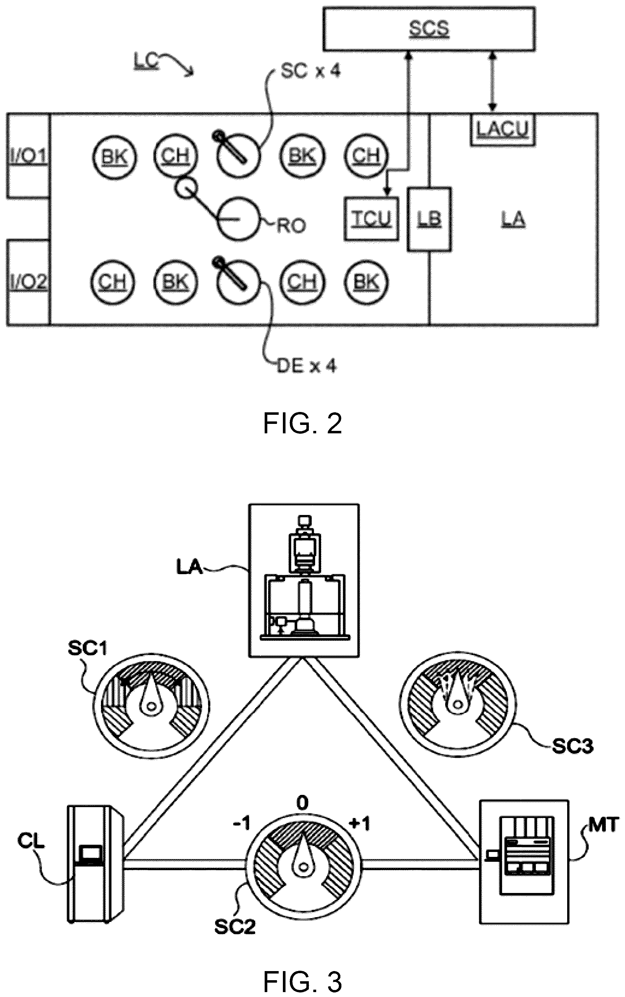

As shown in Figure 2 the lithographic apparatus LA may form part of a lithographic cell LC, also sometimes referred to as a lithocell or (litho)cluster, which often also includes apparatus to perform pre- and post-exposure processes on a substrate W. Conventionally these include spin coaters SC to deposit resist layers, developers DE to develop exposed resist, chill plates CH and bake plates BK, e.g. for conditioning the temperature of substrates W e.g. for conditioning solvents in the resist layers. A substrate handler, or robot, RO picks up substrates W from input/output ports I/O1, I/O2, moves them between the different process apparatus and delivers the substrates W to the loading bay LB of the lithographic apparatus LA. The devices in the lithocell, which are often also collectively referred to as the track, are typically under the control of a track control unit TCU that in itself may be controlled by a supervisory control system SCS, which may also control the lithographic apparatus LA, e.g. via lithography control unit LACU.

In order for the substrates W exposed by the lithographic apparatus LA to be exposed correctly and consistently, it is desirable to inspect substrates to measure properties of patterned structures, such as overlay errors between subsequent layers, line thicknesses, critical dimensions (CD), etc. For this purpose, inspection tools (not shown) may be included in the lithocell LC. If errors are detected, adjustments, for example, may be made to exposures of subsequent substrates or to other processing steps that are to be performed on the substrates W, especially if the inspection is done before other substrates W of the same batch or lot are still to be exposed or processed.

An inspection apparatus, which may also be referred to as a metrology apparatus, is used to determine properties of the substrates W, and in particular, how properties of different substrates W vary or how properties associated with different layers of the same substrate W vary from layer to layer. The inspection apparatus may alternatively be constructed to identify defects on the substrate W and may, for example, be part of the lithocell LC, or may be integrated into the lithographic apparatus LA, or may even be a stand-alone device. The inspection apparatus may measure the properties on a latent image (image in a resist layer after the exposure), or on a semi-latent image (image in a resist layer after a post-exposure bake step PEB), or on a developed resist image (in which the exposed or unexposed parts of the resist have been removed), or even on an etched image (after a pattern transfer step such as etching).

Typically the patterning process in a lithographic apparatus LA is one of the most critical steps in the processing which requires high accuracy of dimensioning and placement of structures on the substrate W. To ensure this high accuracy, three systems may be combined in a so called "holistic" control environment as schematically depicted in Figure 3. One of these systems is the lithographic apparatus LA which is (virtually) connected to a metrology tool MT (a second system) and to a computer system CL (a third system). The key of such "holistic" environment is to optimize the cooperation between these three systems to enhance the overall process window and provide tight control loops to ensure that the patterning performed by the lithographic apparatus LA stays within a process window. The process window defines a range of process parameters (e.g. dose, focus, overlay) within which a specific manufacturing process yields a defined result (e.g. a functional semiconductor device) - typically within which the process parameters in the lithographic process or patterning process are allowed to vary.

The computer system CL may use (part of) the design layout to be patterned to predict which resolution enhancement techniques to use and to perform computational lithography simulations and calculations to determine which mask layout and lithographic apparatus settings achieve the largest overall process window of the patterning process (depicted in Figure 3 by the double arrow in the first scale SC1). Typically, the resolution enhancement techniques are arranged to match the patterning possibilities of the lithographic apparatus LA. The computer system CL may also be used to detect where within the process window the lithographic apparatus LA is currently operating (e.g. using input from the metrology tool MT) to predict whether defects may be present due to e.g. sub-optimal processing (depicted in Figure 3 by the arrow pointing "0" in the second scale SC2).

The metrology tool MT may provide input to the computer system CL to enable accurate simulations and predictions, and may provide feedback to the lithographic apparatus LA to identify possible drifts, e.g. in a calibration status of the lithographic apparatus LA (depicted in Figure 3 by the multiple arrows in the third scale SC3).

In lithographic processes, it is desirable to make frequent measurements of the structures created, e.g., for process control and verification. Tools to make such measurements are typically called metrology tools MT. Different types of metrology tools MT for making such measurements are known, including scanning electron microscopes or various forms of scatterometer metrology tools MT. Scatterometers are versatile instruments which allow measurements of the parameters of a lithographic process by having a sensor in the pupil or a conjugate plane with the pupil of the objective of the scatterometer, measurements usually referred as pupil based measurements, or by having the sensor in the image plane or a plane conjugate with the image plane, in which case the measurements are usually referred as image or field based measurements. Aforementioned scatterometers may measure gratings using light from soft x-ray and visible to near-IR wavelength range.

The scatterometer MT may be an angular resolved scatterometer. In such a scatterometer reconstruction methods may be applied to the measured signal to reconstruct or calculate properties of the grating. Such reconstruction may, for example, result from simulating interaction of scattered radiation with a mathematical model of the target structure and comparing the simulation results with those of a measurement. Parameters of the mathematical model are adjusted until the simulated interaction produces a diffraction pattern similar to that observed from the real target.

The scatterometer MT may be a spectroscopic scatterometer MT. In such spectroscopic scatterometer MT, the radiation emitted by a radiation source is directed onto the target and the reflected or scattered radiation from the target is directed to a spectrometer detector, which measures a spectrum (i.e. a measurement of intensity as a function of wavelength) of the specular reflected radiation. From this data, the structure or profile of the target giving rise to the detected spectrum may be reconstructed, e.g. by Rigorous Coupled Wave Analysis and non-linear regression or by comparison with a library of simulated spectra.

The scatterometer MT may be a ellipsometric scatterometer. The ellipsometric scatterometer allows for determining parameters of a lithographic process by measuring scattered radiation for each polarization states. Such metrology apparatus emits polarized light (such as linear, circular, or elliptic) by using, for example, appropriate polarization filters in the illumination section of the metrology apparatus.

The scatterometer MT may be adapted to measure the overlay of two misaligned gratings or periodic structures by measuring asymmetry in the reflected spectrum and/or the detection configuration, the asymmetry being related to the extent of the overlay. The two (typically overlapping) grating structures may be applied in two different layers (not necessarily consecutive layers), and may be formed substantially at the same position on the wafer. The scatterometer may have a symmetrical detection configuration such that any asymmetry is clearly distinguishable. This provides a straightforward way to measure misalignment in gratings.

Other parameters of interest may be focus and dose. Focus and dose may be determined simultaneously by scatterometry (or alternatively by scanning electron microscopy). A single structure may be used which has a unique combination of critical dimension and sidewall angle measurements for each point in a focus energy matrix (FEM - also referred to as Focus Exposure Matrix). If these unique combinations of critical dimension and sidewall angle are available, the focus and dose values may be uniquely determined from these measurements.

A metrology target may be an ensemble of composite gratings, formed by a lithographic process, mostly in resist, but also after etch process for example. Typically the pitch and line-width of the structures in the gratings strongly depend on the measurement optics (in particular the NA of the optics) to be able to capture diffraction orders coming from the metrology targets. As indicated earlier, the diffracted signal may be used to determine shifts between two layers (also referred to 'overlay') or may be used to reconstruct at least part of the original grating as produced by the lithographic process. This reconstruction may be used to provide guidance of the quality of the lithographic process and may be used to control at least part of the lithographic process. Targets may have smaller sub-segmentation which are configured to mimic dimensions of the functional part of the design layout in a target. Due to this sub-segmentation, the targets will behave more similar to the functional part of the design layout such that the overall process parameter measurements resembles the functional part of the design layout better. The targets may be measured in an underfilled mode or in an overfilled mode. In the underfilled mode, the measurement beam generates a spot that is smaller than the overall target. In the overfilled mode, the measurement beam generates a spot that is larger than the overall target. In such overfilled modes, it may also be possible to measure different targets simultaneously, thus determining different processing parameters at the same time.

Overall measurement quality of a lithographic parameter using a specific target is at least partially determined by the measurement recipe used to measure this lithographic parameter. The term "substrate measurement recipe" may include one or more parameters of the measurement itself, one or more parameters of the one or more patterns measured, or both. For example, if the measurement used in a substrate measurement recipe is a diffraction-based optical measurement, one or more of the parameters of the measurement may include the wavelength of the radiation, the polarization of the radiation, the incident angle of radiation relative to the substrate, the orientation of radiation relative to a pattern on the substrate, etc. One of the criteria to select a measurement recipe may, for example, be a sensitivity of one of the measurement parameters to processing variations.

Metrology and/or inspection tools (also referred to as measurement tools) such as the ones described above often use radiation to obtain measurement data. Depending on the measurement target and the properties to be measured, different types of radiation may be used. One differing property of radiation is the wavelength(s) used to obtain a measurement, as different wavelengths may provide different information about a measurement target. Some measurement tools may use broadband radiation, such as supercontinuum radiation, either to measure using broadband radiation, or to be able to tune and select the measurement wavelength(s) to be used. Depending on the range of output wavelengths and properties of the broadband source, different methods may be used to obtain the broadband radiation. In some implementations for generating broadband radiation, nonlinear effects may be used to broaden narrow wavelength range input radiation (also referred to as pump radiation). Different known setups and methods exist to achieve nonlinear broadening. Often these methods rely on the confinement of the pump radiation to achieve high intensities needed to experience significant nonlinear effects.

As previously discussed, one type of metrology tool is an alignment sensor for positioning different target portions C in the path of the radiation beam B at a focused and aligned position and/or for positioning the patterning device MA with respect to the path of the radiation beam B. Figure 4 schematically depicts a known alignment sensor 100. A known method for aligning a substrate W involves, before lithographic exposure of the substrate W, the substrate W and the patterning device MA being aligned using an alignment sensor 100 such as that illustrated in Fig. 4. The alignment sensor 100 comprises a radiation source 110 (e.g. one or more lasers) configured to emit a radiation beam 120 comprising a plurality of separated wavelengths (e.g. separate bandwidths in the Near-Infra Red (NIR) and/or visible wavelength ranges). A first lens 130 focuses the radiation beam 120 towards a specifically designed diffraction pattern (e.g. a grating P1, P2 provided on a substrate W) referred to in the art as an alignment marker or alignment mark, X0, X1, X2. In the example of Fig. 4, a folding mirror 112 redirects the radiation beam 120 towards the first lens 130. The reflective alignment marker X1 causes diffraction of the radiation beam 120, resulting in -1 and +1 diffraction orders returning back to the first lens 130. The term "diffracted" is intended to include zero-order diffraction from the mark (which may be referred to as reflection). The first lens 130 collimates the diffraction orders -1, +1. The diffraction orders -1, +1 are incident on a second lens 140. The second lens 140 focuses the diffraction orders -1, +1 towards a transmissive reference diffraction pattern 150 (e.g. a reference grating M1, M2 provided on a patterning device MA). The photodetector 160 measures a position of an image of the reflective alignment marker X1 with respect to the reference grating 150 provided on the patterning device MA. Additional optics (not shown) may be included to provide separate beams in case more than one wavelength is created by the radiation source 110. The photodetector 160 may comprise one or more sensing elements or pixels. The photodetector may comprise a sensor array. By interfering the two diffraction orders -1, +1 and using the photodetector 160 to detect the resulting interference pattern, the alignment sensor 100 is configured to determine the position of the substrate W relative to the patterning device MA. As this measurement is repeated for multiple widely separated wavelengths (e.g. wavelength bands separated by about 50 nm or more), alignment information can be determined more accurately as the amount of information about the alignment is increased and may be compared for different wavelengths.

The intensity measured by the photodetector varies sinusoidally as the alignment marker X1 is scanned relative to the radiation beam 120. A single alignment measurement of the type illustrated in Fig. 4 may only fix the position of the alignment mark X1 within a certain range corresponding to one pitch of the alignment mark X1. Coarser measurement techniques may be used in conjunction with this to identify which period of a sine wave is the one containing the marked position. The same process at coarser and/or finer levels may be repeated at different wavelengths for increased accuracy and/or for robust detection of the alignment mark X1 irrespective of the materials from which the alignment mark X1 is made, and materials on and/or below which the alignment mark X1 is provided. The wavelengths may be multiplexed and de-multiplexed optically so as to be processed simultaneously, and/or they may be multiplexed by time division or frequency division.

In the example of Fig. 4, the alignment sensor 100 remains stationary, while it is the substrate W that moves along the positive X direction. The alignment sensor 100 can thus be mounted rigidly and accurately to a reference frame, while effectively scanning the alignment mark X1 in a direction opposite to the direction of movement of substrate W. The substrate W is controlled in this movement by its mounting on a substrate support WT and a substrate positioning system PW controlling the movement of the substrate support MT. A substrate support position sensor (e.g. an interferometer) measures the position of the substrate support WT. One or more alignment marks X0-X2 may be provided on the substrate support WT. A measurement of the position of the alignment marks provided on the substrate support WT allows the position of the substrate support WT as determined by the position sensor to be calibrated (e.g. relative to a frame to which the alignment system 100 is connected). A measurement of the position of the alignment marks X0-X2 provided on the substrate W allows the position of the substrate W relative to the substrate support WT to be determined.

Aligning the substrate W at more positions X0, X2 improves the alignment accuracy but comes at a throughput penalty for the known alignment system 100, which may form part of a metrology tool or lithographic apparatus. The known alignment system 100 and method thus has the limitation that it can measure only one alignment marker X0-X2 at a time. The known alignment system 100 and method utilizes bulky optics such that the size of the alignment system 100 prohibits the application of multiple alignment beams simultaneously measuring the same substrate W at different positions corresponding to different alignment markers X0-X2.

In photonic integrated circuits (PICs), electromagnetic radiation is guided through a waveguide inside a suitable substrate or chip. Coupling electromagnetic radiation into and out of the chip (i.e. into and out of free space) can be challenging. Coupling is particularly difficult when the relatively small-sized chip is required to emit and/or receive electromagnetic radiation from a comparatively long distance (e.g. about 1 cm or more) whilst operating at multiple wavelengths as may be required in free-space optical communication or optical sensing (e.g. a metrology tool such as an alignment sensor). A known method of coupling electromagnetic radiation between a chip and free space involves the use of a grating coupler. An apodized grating provides a focusing effect in which the focal position depends upon a wavelength of the electromagnetic radiation. Alternatively, a small lens or "micro-lens" may be provided to provide focusing. In either case, a single grating coupler is not able to focus electromagnetic radiation comprising multiple different wavelengths to the same focal position. As such, for known methods, a different grating is required for each wavelength, which increases the size of known systems. In addition, if it is desired to focus different wavelengths to substantially the same focal position in free space, and/or to capture the different wavelengths from substantially the same location in free space, the different gratings begin to overlap with each other on the chip, which negatively impacts the focusing effect. Hence, a need exists to provide an optical coupler that can emit and/or receive electromagnetic radiation comprising multiple different wavelengths to or from substantially the same focal position with respect to a plane of a photonic chip.

Known optical couplers such as, for example, a grating coupler comprising an apodized filling factor and/or elliptically curved grating lines may provide sufficient control to create a substantially uniform intensity profile along the spot diameter and to focus the electromagnetic radiation at a given target spot for at least some applications. However, such known optical couplers only operate at a single wavelength. This is because diffraction is highly dependent upon the wavelength of the electromagnetic radiation, therefore introducing additional wavelengths introduces diffraction orders at a greater range of angles and thereby significantly reduces a coupling efficiency of the known optical couplers. Bi-wavelength operation may be possible by positioning one input waveguide configured to guide a first wavelength at one side of the known optical coupler, and positioning a second input waveguide configured to guide a second wavelength orthogonally at an adjacent side of the known optical coupler. However, this arrangement reduces the control of the intensity profile of the electromagnetic radiation due to the difference in diffraction order angles being orthogonal for the first and second wavelengths, resulting in a large range of angles and a correspondingly low coupling efficiency. This arrangement also requires an extra waveguide taper for the second orthogonally arranged waveguide, thus considerably increasing the size of the resulting device.

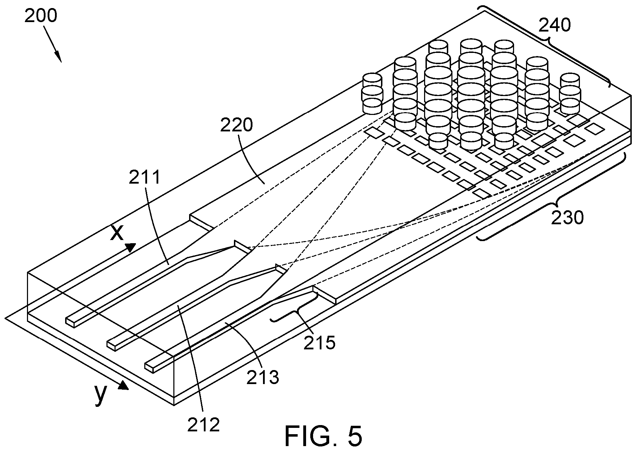

Figure 5 schematically depicts a first optical coupler 200 for a photonic integrated circuit in accordance with the present disclosure. The optical coupler 200 comprises a first channel waveguide 211 configured to guide electromagnetic radiation comprising a first wavelength. The optical coupler 200 comprises a second channel waveguide 212 configured to guide electromagnetic radiation comprising a second wavelength that is different to the first wavelength. In the example of Fig. 5, the optical coupler 200 comprises a third channel waveguide 213 configured to guide electromagnetic radiation comprising a third wavelength that is different to the first wavelength and the second wavelength. The first wavelength may form part of a first bandwidth. The first wavelength may be a central wavelength of the first bandwidth. The second wavelength may form part of a second bandwidth. The second wavelength may be a central wavelength of the second bandwidth. The third wavelength may form part of a third bandwidth. The third wavelength may be a central wavelength of the third bandwidth. The first, second and third bandwidths may be different. The first, second and third bandwidths may not overlap. In general, the optical coupler 200 may comprise two channel waveguides or more, for guiding two different wavelengths or more. The wavelengths of electromagnetic radiation being used at least partly depend on the desired application. In the example of lithographic or metrology alignment measurements, the different wavelengths guided by the channel waveguides 211-213 may be selected from visible wavelengths and/or infrared wavelengths. For example, the first, second and third wavelengths may be about 500 nm or more. The first, second and third wavelength may be about 1600 nm or less. The first, second and third wavelengths may be about 900 nm or less.

The optical coupler 200 comprises a slab waveguide 220 optically coupled to the first, second and third channel waveguides 211-213. The slab waveguide 220 is configured to guide electromagnetic radiation comprising the first, second and third wavelengths. The slab waveguide 220 has a width that is greater than a width of each of the channel waveguides 211-213. As such, a maximum spatial extent of the electromagnetic radiation in the slab waveguide 220 may be greater than a maximum spatial extent of the electromagnetic radiation in the channel waveguides 211-213.

For example, when the optical coupler 200 acts as an emitter, the slab waveguide 220 may be configured to allow spatial expansion of the electromagnetic radiation received from one or more of the channel waveguides 211-213. For example, when the optical coupler 200 acts as a receiver, the slab waveguide 220 may be configured to allow spatial contraction of the electromagnetic radiation provided to one or more of the channel waveguides 211-213.

Each of the waveguides 211-213 may comprise an adiabatic waveguide taper 215. The adiabatic waveguide taper 215 may be configured to change a size and/or shape of the electromagnetic radiation. This may reduce unwanted scattering of the electromagnetic radiation and increase an optical coupling efficiency between at least one of the channel waveguides 211-213 and the slab waveguide 220. For example, when the optical coupler 200 acts as an emitter, the adiabatic waveguide taper 215 may be configured to spatially expand electromagnetic radiation received from a respective channel waveguide 211-213 into the slab waveguide 220. For example, when the optical coupler 200 acts as a receiver, the adiabatic waveguide taper 215 may be configured to spatially contract electromagnetic radiation received from the slab waveguide 220 into a respective channel waveguide 211-213. The adiabatic waveguide taper 215 may be thought of as a funnel for collecting or distributing electromagnetic radiation.

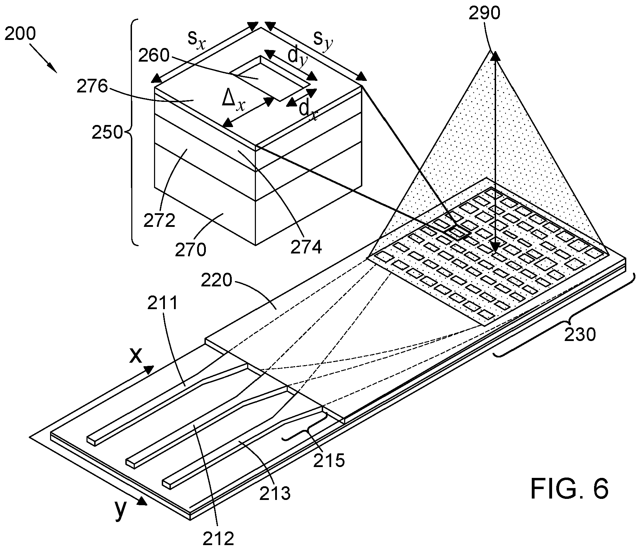

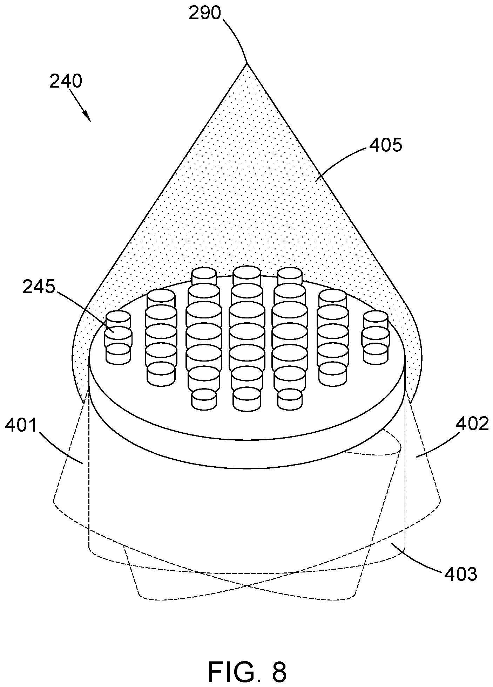

The optical coupler 200 comprises a computer generated waveguide hologram (CGWH) 230 optically coupled to the slab waveguide 220. The optical coupler 200 comprises a metasurface 240 optically coupled to the computer generated waveguide hologram 230. The arrangement of the computer generated waveguide hologram 230 and the metasurface 240 may be understood as a metasurface-computer waveguide hologram hybrid coupler 230, 240. The computer generated waveguide hologram 230 of Fig. 5 is shown and described in greater detail with reference to Figure 6. The metasurface 240 of Fig. 5 is shown and described in greater detail with reference to Figure 8.

When the optical coupler 200 acts as an emitter, the computer generated waveguide hologram 230 is configured to controllably emit electromagnetic radiation comprising multiple wavelengths. The computer generated waveguide hologram 230 may be configured to emit electromagnetic radiation having a desired intensity profile (e.g. a substantially Gaussian profile). In the example of Fig. 5, the computer generated waveguide hologram 230 emits electromagnetic radiation comprising multiple wavelengths (i.e. the first, second and third wavelengths provided by the channel waveguides 211-213) upwardly in the Z direction (i.e. orthogonal to the X and Y directions). The computer generated waveguide hologram 230 may be configured to direct and focus electromagnetic radiation to a desired focal point in free space. When the optical coupler 200 acts as an emitter, the metasurface 240 acts to improve a focussing efficiency of the optical coupler 200. That is, as an emitter, the optical coupler 200 is configured to emit and focus multiple wavelengths of electromagnetic radiation received from respective waveguides 211-213 to substantially the same location in free space. The optical coupler 200 is capable of emitting and focusing electromagnetic radiation received from multiple single-mode waveguides (e.g. configured to guide separate bandwidths of electromagnetic radiation) in a direction that is substantially orthogonal to a plane of the optical coupler 200 (e.g., in the example of Fig. 5, in a substantially vertical direction). The optical coupler 200 may be configured to emit and focus at least two different wavelengths to substantially the same location in free space.

When the optical coupler 200 acts as a receiver, the metasurface 240 is configured to collect electromagnetic radiation comprising multiple wavelengths from free space and distribute the electromagnetic radiation across the computer generate waveguide hologram 230. When the optical coupler 200 acts as a receiver, the computer generated waveguide hologram 230 is configured to separate the electromagnetic radiation received from the metasurface 240 into separate beams comprising different wavelengths and direct said beams through the slab waveguide 220 to respective channel waveguides 211-213. That is, as receiver, the optical coupler 200 is configured to collect multiple wavelengths of electromagnetic radiation (e.g. separate bandwidths of electromagnetic radiation) received from free space and separate said wavelengths into respective waveguides 211-213. The optical coupler 200 may be configured to receive collimated electromagnetic radiation comprising multiple wavelengths (e.g. separate bandwidths of electromagnetic radiation) from free space.

The optical coupler 200 of Fig. 5 may be formed across two layers. The channel waveguides 211-213, slab waveguide 220 and computer generated waveguide hologram 230 may be formed on a first layer and the metasurface 240 may be formed on a second layer. The second layer may stacked on top of the first layer. The first and second layers may form a monolithic device.

Figure 6 schematically depicts the first optical coupler 200 of Fig. 5 with the second layer comprising the metasurface 240 no longer present, thereby revealing the computer generated waveguide hologram 230 in greater detail. The computer generated waveguide hologram 230 may comprise an arrangement of unit cells 250. The arrangement of unit cells 250 may comprise a two dimensional array of unit cells 250. In the example of Fig. 6, the unit cells 250 are generally rectangular in the plane of the optical coupler 200 (i.e. an extent of the unit cell 250 in the x-direction $s_x$ is greater than an extent of the unit cell 250 in the y-direction $s_y$). The unit cells 250 may take other forms.

Fig. 6 shows a magnified cross-sectional perspective view of one of the unit cells 250. The unit cells 250 comprise one or more structures 260. In the example of Fig. 6, the structures 260 comprise generally rectangular wells (i.e. $d_y$ is greater than $d_x$). The structure 260 may take other forms. A waveguide hologram may be understood as a hologram encoded into an arrangement of structures 260 (e.g. nanostructures) formed on a waveguide layer (e.g. etched through to or deposited on the slab waveguide 220) through which the hologram may be illuminated. An electromagnetic field solver method may be used to simulate the effects of and/or design the computer generated waveguide hologram 230. For example, Finite-Difference Time Domain (FDTD) modelling may be used to simulate the effects of and/or design the computer generated waveguide hologram 230. Following the results of the simulation, corresponding unit cells 250 and structures 260 may be fabricated using lithography such as, for example, optical or electron beam lithography. The structures 260 may be fabricated at least in part using wafer-scale semiconductor manufacturing techniques. These holograms may be referred to as computer-generated waveguide holograms 230 (CGWH).

Each structure 260 is configured to scatter a portion of incident electromagnetic radiation out-of-plane, thereby emitting the electromagnetic radiation. Each structure 260 is also configured to introduce a phase shift to the scattered electromagnetic radiation as well as the remaining electromagnetic radiation propagating in the slab waveguide 220. The size and/or shapes of the structures 260 may vary across the arrangement of unit cells 250 to achieve desired emission and/or phase shift characteristics. In this regard, the structures 260 may comprise one or more subwavelength dimensions. For example, a pitch of the unit cells 250 in the y-direction $s_y$ may be selected as sub-wavelength (i.e. smaller than the smallest wavelength of electromagnetic radiation that is to be coupled by the optical coupler 200) such that the guided modes of electromagnetic radiation only interacts with the structures 260, and thus generates diffraction phenomena in, the x-direction. The structures 260 may comprise nanostructures. A size of each structure 260 $d_x$, $d_y$ may be selected to obtain a desired intensity profile (e.g. a Gaussian profile) of the electromagnetic radiation that is emitted by scattering from the structures 260. A size of the structure 260 within each unit cell 250 may vary across at least part of the arrangement of unit cells 250. An offset $\Delta x$ of each structure 260 relative to an edge of its corresponding unit cell 250 may be selected such that the emitted electromagnetic radiation interferes constructively at a desired target location in free space. A distance between the structures 260 of two neighboring unit cells 250 may vary across at least part of the arrangement of unit cells 250. This distance may be referred to as a local period. The local period may vary across the computer generated waveguide hologram 230. This variation adjusts a phase profile of the incident electromagnetic radiation. A filling ratio may be understood as an in-plane area of a structure 260 relative to the in-plane area of the unit cell 250 that the structure 260 occupies. The filling ratio may vary across the arrangement of unit cells 250. Known computer generated waveguide holograms are only designed to achieve a desired phase profile of an emitted beam. That is, in known computer generated waveguide holograms, the positions of the structures within the unit cells are optimized, but the filling ratio across these holograms is kept constant. In the optical coupler 200 according to the present disclosure, by varying the filling ratios across the arrangement of unit cells 250, the structures 260 may provide stronger scattering of the electromagnetic radiation whilst simultaneously ensuring a uniform intensity profile of the emitted beam.

The optical coupler 200 may be formed using a variety of material platforms depending at least in part upon the wavelengths of electromagnetic radiation that are to be transmitted by the optical coupler 200. In the example of Figs. 5 and 6, the optical coupler 200 is formed on an InP-based platform. The optical coupler 200 may be formed on an InP Membrane On-Silicon (IMOS) platform. A silicon substrate 270 is provided, upon which an adhesive layer 272 (e.g. benzocyclobutene "BCB" glue) is deposited. The channel waveguides 211-213 and slab waveguide 220 are formed in a layer of InP 274 which is attached to the silicon substrate 270 by the adhesive layer 272. In the example of Fig. 6, a layer 276 having a lower refractive index than the slab waveguide 220 is provided on the slab waveguide 220, and the structures 260 are etched into said layer 276. That is, in the example of Fig. 6, the structures 260 correspond to a region of the layer 276 that has been etched away to reveal a portion of the underlying slab waveguide 220. Alternative materials and platforms may be used.

An extent of the unit cells 250 in the y-direction $s_y$ may be selected as being subwavelength (i.e. smaller than the smallest wavelength of electromagnetic radiation that is to be coupled by the optical coupler 200) such that the guided modes of electromagnetic radiation only interact with the unit cells 250, and thus generate diffraction phenomena in, the x-direction. An extent of the unit cells 250 in the in-plane orthogonal direction (i.e. the x-direction) may be selected to increase coupling efficiency for the wavelength that is to be coupled. An extent of the unit cells 250 in the direction in which diffraction phenomena is desired (e.g. the x-direction) may be similar to the periodicity of a grating coupler configured for use with a given wavelength that is to be coupled by the optical coupler 200. The periodicity of a grating coupler configured for use with a selected central wavelength may be determined via a waveguide phase matching equation such as, for example, the following relationship:

$$n_{sup} k_0 \sin \theta_1 = \beta_0 - \frac{2\pi m}{d_0}$$

where $n_{sup}$ is a refractive index of a superstrate of the waveguide (e.g. a refractive index of the third layer 276 in which the structures 260 are formed), $k_0 = \frac{2\pi}{\lambda}$ where $\lambda$ is the selected central wavelength, $\theta_1$ is a coupling angle (e.g. when acting as an emitter, the angle at which the electromagnetic radiation is emitted into free space by the optical coupler 200), $\beta_0$ is a wave vector of a waveguide mode guided by the waveguide, $m$ is an integer and $d_0$ is the periodicity of the grating coupler. $\beta_0$ may be represented as $\frac{n_{eff} 2\pi}{\lambda}$ where $n_{eff}$ is the effective refractive index of the waveguide which at least partially accounts for material properties and a perturbation caused by the grating coupler to the waveguide mode compared to a nominal waveguide (i.e. without a grating coupler present). $\beta_0$ and $n_{eff}$ are values that may be found via numerical simulation (e.g. using the previously mentioned electromagnetic field solver methods). The periodicity of the grating coupler may also be selected to achieve a desired coupling angle. Selecting $\frac{2\pi}{d_0}$ (e.g. to be greater than or less than $\beta_0$) may at least partially determine an angle of emission into free space.

A size of the structures 260 may be at least partially determined by a critical dimension limit (i.e. a smallest feature size) of the manufacturing process used to form the optical coupler 200. The critical dimension may be about 10 nm or more. The critical dimension may be about 150 nm or less. The critical dimension may be about 80 nm or more. The critical dimension may be about 100 nm or less. The structures 260 may have an extent that is equal to or greater than the critical dimension. The structures 260 may have an extent that is less than an extent of the unit cell 250 hosting the structure 260.

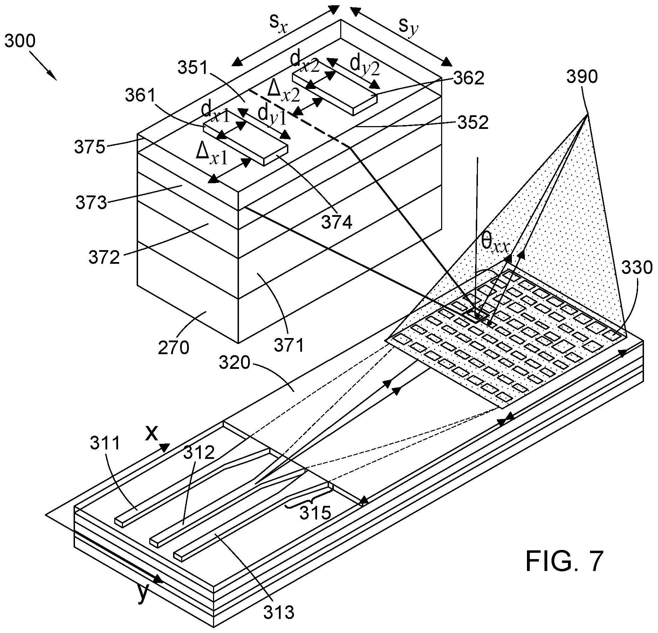

Figure 7 schematically depicts an optical coupler 300 formed on an SiN-based platform in accordance with the present disclosure. A silicon substrate 270 is provided, upon which a first layer of $SiO_2$ 371 is formed. A first layer of SiN 372 is formed on the first layer of $SiO_2$ 371. A second layer of $SiO_2$ 373 is formed on the first layer of SiN 372. A second layer of SiN 374 is formed on the second layer of $SiO_2$ 373. A third layer of $SiO_2$ 375 is formed on the second layer of SiN 374. In the example of Fig. 7, the structures 361, 362 are formed by etching the second layer of SiN to form columns on the second layer of $SiO_2$.

Like the optical coupler of Fig. 6, the optical coupler of Fig. 7 comprises three channel waveguides 311-313 comprising adiabatic waveguide tapers 315, a slab waveguide 320, and a computer generated waveguide hologram 330. In the example of Fig. 7, a magnified cross-sectional perspective view of two unit cells 351, 352 (separated by a dashed line) belonging to the computer generated waveguide hologram 330 is shown. In the example of Fig. 7, the unit cells 351, 352 are generally rectangular having a first extent $s_x$ in the x direction and a second extent $s_y$ in the y direction. In the example of Fig. 7, the computer generated waveguide hologram 330 is configured to emit and focus electromagnetic radiation comprising thee different wavelength bandwidths to a focal point 390 that is off-axis by an angle $\theta_{xz}$ relative to the Z direction. The focused electromagnetic radiation may have a diameter of about 40 $\mu$m or less at the focal point 390. This off-axis focusing is achieved by the arrangement of structures 361, 362 in the unit cells 351, 352. The first unit cell 351 comprises a first structure 361 having an extent in the x-direction $d_{x1}$, an extent in the y-direction $d_{y1}$, and an offset relative to an edge of the unit cell 351 in the x-direction $\Delta_{x1}$. The second unit cell 352 comprises a second structure 362 having an extent in the x-direction $d_{x2}$, an extent in the y-direction $d_{y2}$, and an offset relative to an edge of the unit cell 352 in the x-direction $\Delta_{x2}$. In the example of Fig. 7, the extent of the first structure 361 in the x-direction $d_{x1}$ is greater than the extent of the second structure 362 in the x-direction $d_{x2}$. In the example of Fig. 7, the extent of the first structure 361 in the y-direction $d_{y1}$ is greater than the extent of the second structure 362 in the y-direction $dy_2$. In the exam-

ple of Fig. 7, the offset relative to an edge of the unit cell 351 in the x-direction $\Delta_{x1}$ of the first structure 361 is greater than the offset relative to an edge of the unit cell 352 in the x-direction $\Delta_{x2}$ of the second structure 362. By varying these parameters across the computer generated waveguide hologram, focussing the electromagnetic radiation to a desired off-axis location 390 may be achieved.

The SiN-based platform may enable operation over the visible and/or near-infrared (NIR) wavelength regimes. For example, the channel waveguides 311-313 and/or the slab waveguide 320 may be formed of SiN. The platform can include active devices (e.g. lasers and/or photodiodes) using hybrid integration with other platforms such as InP, GaAs, etc. Alternatively, external devices may be used. Since no external optics are required to focus the emitted beams, the chip packaging is highly simplified compared to known optical couplers. The slab waveguide 320 may be formed on a different platform such as, for example, an InP-based platform, an example of which is shown in Figs. 5 and 6. Other materials may be used. The selection of materials may at least partly depend upon the wavelengths of electromagnetic radiation that are to be coupled by the optical coupler 200, 300. In general, the selected materials should have an acceptable transmissivity in the desired wavelength range for a given application. For example, for an alignment measurement performed using visible wavelengths by a metrology system or a lithographic apparatus, an optical coupler formed on an SiN-based platform may be preferable. As another example, for an optical process performed using infrared wavelengths, an optical coupler formed on an InP-based platform may be preferable.

A multi-wavelength computer generated waveguide hologram, such as those shown in Fig. 6 and Fig. 7, may be designed to focus the emitted electromagnetic radiation to a given location 290 in free space (which, in the example of Fig. 6, is about 10 mm away from the optical coupler 200) without the need for a metasurface 240. However, a multi-wavelength computer generated waveguide hologram may emit additional unwanted beams in unintended directions. The number of emitted beams may scale with the number of operating wavelengths. Consequently, an efficiency of such an optical coupler may decrease and, if the additional beams are not blocked (e.g. by the external packaging of the optical coupler), these additional beams may be considered to be "ghost" beams which may negatively effect an application of the optical coupler (e.g. a lithographic alignment measurement). By providing a metasurface 240, such as that shown in Fig. 5, the number of unwanted additional beams travelling in unintended directions may be reduced. A separation between the plane of the photonic integrated circuit and the location 290 in free space may be about 10 mm or less. A separation between the plane of the photonic integrated circuit and the location 290 in free space may be about 1 mm or more. For example, the separation between the plane of the photonic integrated circuit and the location 290 in free space may be about 3 mm.

In an alternative arrangement to those shown in Figs. 5-7, the computer generated waveguide hologram may comprise a constant offset between the structures in the unit cells, similar to a grating coupler. Incident electromagnetic radiation comprising multiple wavelengths may be emitted in a desired direction (e.g. upward) at different angles corresponding to the different wavelengths. By selecting a size and/or shape of each structure, the emitted electromagnetic radiation may be emitted as two-dimensional Gaussian for the different wavelengths. The metasurface may then be configured to focus and redirect the beams to the same target in free space.

Figure 8 schematically depicts a metasurface 240 in accordance with the present disclosure. The metasurface 240 comprises an arrangement (e.g. a two-dimensional array) of metasurface structures 245 configured to introduce a phase shift to incident electromagnetic radiation. A form of the metasurface structures 245 varies across at least part of the arrangement of metasurface structures 245. The metasurface 240 may comprise a single layer of metasurface structures 245. Alternatively, the metasurface 240 may comprise a plurality of layers (not shown) of metasurface structures 245. The local phase shift applied to the electromagnetic radiation by a metasurface structure 245 may at least partially depend upon a form of the metasurface structure 245. The form of the metasurface structure 245 may comprise a size and/or a shape of the metasurface structure 245. The metasurface 240 may be a metalens.

In the example of Fig. 8, the metasurface structures 245 comprise circular pillars having varying diameters. The pillars may be nanopillars. In the example of Fig. 8, a diameter of the metasurface structures 245 increases towards a centre of the metasurface 240. Other shapes and/or arrangements of metasurface structure 245 may be used. By tailoring the size and/or shape of each metasurface structure 245, the electrical field of incident electromagnetic radiation may be adjusted and thereby controlled at each point in the arrangement of metasurface structures 245, allowing the manipulation of the overall amplitude and phase of the resulting beam. The metasurface structures 245 may be formed of a suitable dielectric material such as, for example, silicon nitride, amorphous silicon, titanium oxide, etc.

Different wavelengths of electromagnetic radiation are emitted from the computer generated waveguide hologram at different angles due to diffraction effects. The metasurface 240 may be configured to collect these different wavelengths from the different angles and focus the different wavelengths to substantially the same focal spot in free space. When the optical coupler 200, 300 acts as an emitter, the form of the metasurface structures 245 may vary across at least part of the arrangement of metasurface structures 245 such that a first beam 401 of electromagnetic radiation comprising the first wavelength, a second beam 402 of electromagnetic radiation comprising the second wavelength, and a third beam 403 of electromagnetic radiation comprising the third wavelength, each beam having a different angle of incidence due to diffraction effects after interaction with the computer generated waveguide hologram, are focussed to substantially the same focal point 290. When the optical coupler 200, 300 acts as a receiver, the form of the metasurface structures 245 may vary across at least part of the arrangement of metasurface structures 245 such that a beam electromagnetic radiation comprising multiple wavelengths 405 is separated into different beams comprising the different wavelengths 401-403 propagating in different directions. Figure 8 shows an example of a tri-wavelength metasurface 240 in which electromagnetic radiation at each wavelength arrives under a different angle. As the upwardly scattered electromagnetic radiation propagates through the metasurface, its phase, and to a lesser extent its amplitude, locally changes depending on the size and/or shape of the metasurface structures 245. An advantage of the computer generated waveguide hologram is that it may be used to controllably emit electromagnetic radiation in a desired direction across a relatively large area, while the metasurface flexibly controls the phase of the electromagnetic radiation across the multiple wavelengths. By varying the size and/or shape (e.g. varying diameters of the nanopillars) across the metasurface 240, different wavelengths of electromagnetic radiation may be focused to substantially the same focal spot. In general, the extents of the metasurface structures 245 (e.g. diameters of the nanopillars) may correspond to the extents $d_x$, $d_y$ of the structures 260, 361, 362 of the CGWH 230, 330. A size of the metasurface structures 245 may be at least partially determined by a critical dimension limit (i.e. a smallest feature size) of the manufacturing process used to form the metasurface 240. The critical dimension may be about 10 nm or more. The critical dimension may be about 150 nm or less. The critical dimension may be about 80 nm or more. The critical dimension may be about 100 nm or less. The metasurface structures 245 may have an extent that is equal to or greater than the critical dimension. The metasurface structures 245 may have an extent that is less than an extent of the unit cells 250 of the CGWH 230, 330.

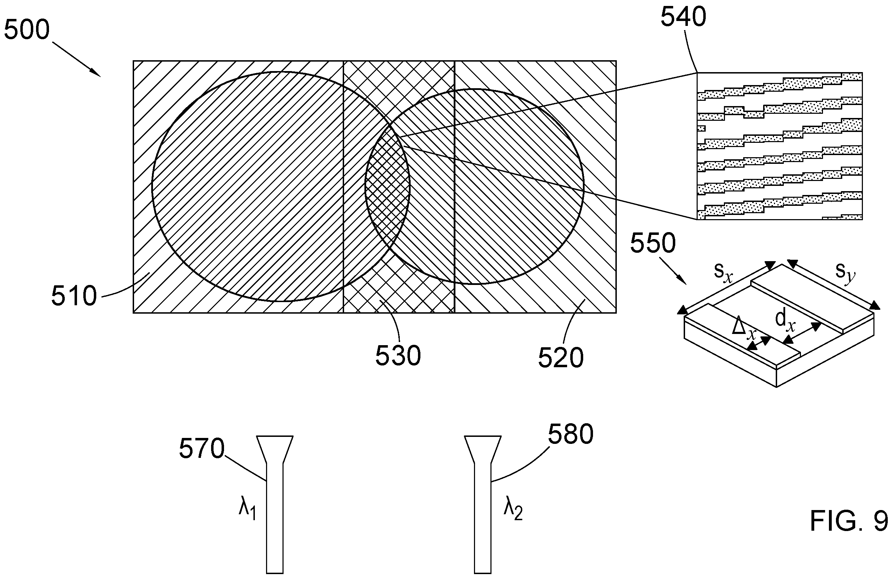

Figure 9 schematically depicts an alternative optical coupler 500 in accordance with the present disclosure. The optical coupler 500 comprises a first region 510 configured to couple a first wavelength of electromagnetic radiation. The optical coupler 500 comprises a second region 520 configured to couple a second wavelength of electromagnetic radiation that is different to the first wavelength of electromagnetic radiation. The optical coupler 500 comprises an intermediate region 530 located between the first and second regions 510, 520 and configured to couple both the first and second wavelengths of electromagnetic radiation. The first region 510 comprises a first computer generated waveguide hologram. The second region 520 comprises a second computer generated waveguide hologram having a different arrangement of unit cells and structures compared to the first region 510. The intermediate region 530 comprises an overlapping of both the first and second computer generated waveguide holograms. The intermediate region 530 may be designed based on a convolution of the computer generated waveguide holograms of the first and second regions 510, 520.

Fig. 9 shows a magnified view 540 from above a portion of the third region 530 alongside a cross-sectional perspective view 550 of one of the unit cells $s_x$, $s_y$ of the optical coupler 500. The unit cell has a similar arrangement to that shown in Fig. 7. As can be seen, the extents $d_x$ and offsets $\Delta x$ of the structures 560 of the unit cell vary across the third region 530 such that the structures form a generally diagonal pattern in the third region 530. The extents $d_x$ and offsets $\Delta x$ of the structures 560 of the unit cells differ between the first and second regions 510, 520 in accordance with the wavelengths that are to be coupled by the first and second regions 510, 520. The size and shape of the structures and unit cells may be selected and vary as previously described in relation to Figures 6 and 7. As can be seen from the cross-sectional perspective view 550 of one of the unit cells $s_x$, $s_y$, the CGWH corresponds to that shown in Figure 6 except that the extent of the structures in the y direction $d_y$ is substantially equal to the extent of the unit cells 250 in the y direction $s_y$. Alternatively, the value of $d_y$ may in a manner similar to that described in relation to Figure 6.

The optical coupler may act as an emitter, a receiver or a transceiver. When acting as a receiver, the optical coupler of Fig. 9 may be understood as a multi-wavelength overlapping receiving coupler. That is, an on-chip optical coupler that may be used to receive multiple collimated beams comprising different wavelengths whose centers are offset from each other but partially overlap at the chip plane. The optical coupler 500 may be used to couple the different wavelengths into different on-chip waveguides 570, 580. The optical coupler 500 comprises a multi-wavelength computer generated waveguide hologram in which different areas or regions of the hologram take different forms (e.g. comprise structure having different sizes and/or shapes) depending on the received beams. The received beams may have widely separated wavelengths (e.g. separated by about 50 nm or more). The optical coupler may also be used reciprocally to emit different collimated beams. The optical coupler 500 may be formed on a SiN-based platform or an InP-based platform.

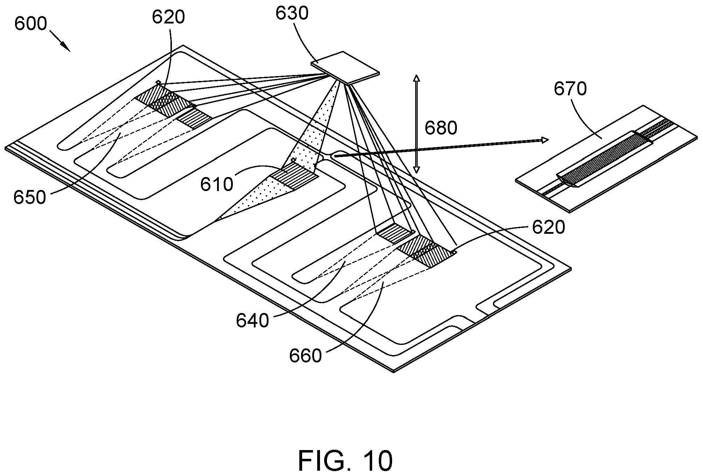

Figure 10 schematically depicts a photonic integrated circuit 600 in accordance with the present disclosure. The photonic integrated circuit 600 comprises a first optical coupler 610 and a pair of second optical couplers 620. The first optical coupler 610 is a computer generated waveguide hologram-metasurface hybrid optical coupler, such as those shown and described in connection with Figs. 5-8. The second optical couplers 620 are alternative optical couplers such as that shown and described in connection with Fig. 9. The photonic integrated circuit 600 may be monolithic. The photonic integrated circuit 600 may be used as an integrated alignment sensing system.

In the example of Fig. 10, the computer generated waveguide hologram-metasurface hybrid optical coupler 610 emits and focusses three different wavelengths to substantially the same point in free space which, in the example of Fig. 10, is occupied by an alignment marker 630. That is, the first optical coupler 610 is configured to emit electromagnetic radiation comprising a plurality of different wavelengths at a target mark 630. In a similar manner to that described in connection with Fig. 4, the alignment marker 630 diffracts the incident electromagnetic radiation into +1 and -1 diffraction orders for each of the different wavelengths. As previously discussed, the angles of diffraction vary in accordance with wavelength. A first wavelength 640 diffracts at a first pair of angles such that the first wavelength is incident upon the photonic integrated circuit 600 in isolation (i.e. without overlapping with any other wavelengths). However, second and third wavelengths 650, 660 diffract at second and third pairs of angles such that the second and third wavelengths 650, 660 partially overlap at the photonic integrated circuit 600. The alternative optical couplers 620 are capable of coupling the second wavelength 650 to a first region (e.g. the first region 510 of Fig. 9), the third wavelength 660 to a second region (e.g. the second region 520 shown in Fig. 9) and the overlapping portion of the second and third wavelengths 650, 660 to a third region (e.g. the intermediate region 530 shown in Fig. 9). That is, the receiving couplers 620 are partially multi-wavelength in the regions where the different wavelengths of electromagnetic radiation overlap on the photonic integrated circuit 600. The respective -1 and +1 diffraction orders are interfered with each other using a multimode interference coupler 670. The second optical couplers 620 are configured to receive diffracted electromagnetic radiation from the target mark 630 and separate said electromagnetic radiation into different waveguides. By analyzing the interference of the different wavelengths with a photodetector (not shown), the relative position of the alignment marker 630 can be determined (e.g. in a similar manner to that described in connection with Fig. 4). Some semiconductor wafers comprise several variations of alignment marker 630 (e.g. having different grating periods) which may be investigated using the different wavelengths 640-660. A separation 680 between the plane of the photonic integrated circuit 600 and the alignment marker 630 may be about 10 mm or less. A separation 680 between the plane of the photonic integrated circuit 600 and the alignment marker 630 may be about 1 mm or more. For example, the separation 680 between the plane of the photonic integrated circuit 600 and the alignment marker 630 may be about 3 mm.

By using photonic integration technology, the present disclosure provides a free-space optical coupling circuit of an integrated alignment sensor for wafer lithography. The multi-wavelength emitter and several overlapping receiver are capable of illuminating different alignment markers on a wafer and capturing the resulting diffraction orders, respectively. The more wavelengths used the more accurate the relative position of the alignment marker man be determined. The photonic integrated circuit 600 of the present disclosure avoids the use of bulky traditional optical element, and thereby significantly reducing the size and weight of the resulting alignment sensor compared to known alignment sensors (such as that shown in Fig. 4). As such, a plurality of said photonic integrated circuits 600 may be compactly mounted together, thereby enabling parallel sensing of multiple alignment markers.

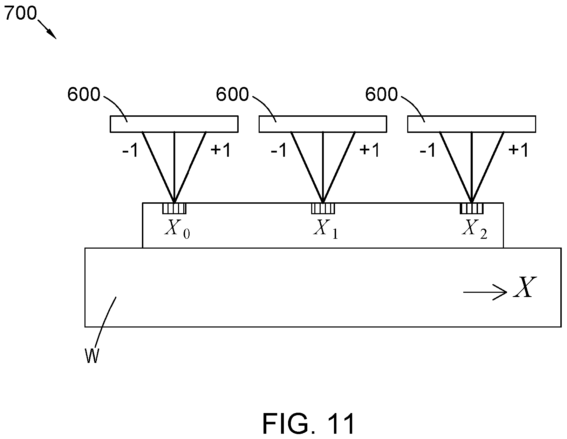

Figure 11 schematically depicts an optical metrology system 700 in accordance with the present disclosure. The optical metrology system 700 has a similar measurement principle to that discussed in connection with Fig. 4. However, the optical metrology system 700 of Fig. 11 comprises three photonic integrated circuits 600 corresponding to that shown in Fig. 10. In the example of Fig. 11, all three of the photonic integrated circuits 600 are configured to simultaneously emit electromagnetic radiation to, and receive diffracted electromagnetic radiation from, three separated target marks X0, X1, X2 located on the wafer W. The photonic integrated circuits 600 work in parallel to align the wafer W (e.g. with respect to a mask MA such as that shown in Fig. 1) at multiple positions on the wafer W without any throughput penalty (unlike the known alignment system of Fig. 4). A lithographic apparatus such as that shown in Fig. 1 may comprise the optical metrology system of Fig. 11 and thereby increase its throughput.

The integrated computer generated waveguide hologram-metasurface hybrid and/or partially overlapping receiving couplers may directly be connected to other circuit elements on the same photonic integrated circuit using standard building blocks. In free space, these couplers may be flexibly designed to focus electromagnetic radiation at, or receive electromagnetic radiation from, any desired target. The target may be different for each operating wavelength.

Although specific reference is made to "metrology apparatus / tool / system" or "inspection apparatus / tool / system", these terms may refer to the same or similar types of tools, apparatuses or systems. For example, the inspection or metrology apparatus that comprises an embodiment of the invention may be used to determine characteristics of structures on a substrate or on a wafer. For example, the inspection apparatus or metrology apparatus that comprises an embodiment of the invention may be used to detect defects of a substrate or defects of structures on a substrate or on a wafer. In such an embodiment, a characteristic of interest of the structure on the substrate may relate to defects in the structure, the absence of a specific part of the structure, or the presence of an unwanted structure on the substrate or on the wafer.

Although specific reference may be made in this text to the use of lithographic apparatus in the manufacture of ICs, it should be understood that the lithographic apparatus described herein may have other applications. Possible other applications include the manufacture of integrated optical systems, guidance and detection patterns for magnetic domain memories, flat-panel displays, liquid-crystal displays (LCDs), thin-film magnetic heads, etc.

Although specific reference may be made in this text to embodiments of the invention in the context of a lithographic apparatus, embodiments of the invention may be used in other apparatus. Embodiments of the invention may form part of a mask inspection apparatus, a metrology apparatus, or any apparatus that measures or processes an object such as a wafer (or other substrate) or mask (or other patterning device). These apparatus may be generally referred to as lithographic tools. Such a lithographic tool may use vacuum conditions or ambient (non-vacuum) conditions.

Although specific reference may have been made above to the use of embodiments of the invention in the context of optical lithography, it will be appreciated that the invention, where the context allows, is not limited to optical lithography and may be used in other applications, for example imprint lithography.

While specific embodiments of the invention have been described above, it will be appreciated that the invention may be practiced otherwise than as described. The descriptions above are intended to be illustrative, not limiting. Thus it will be apparent to one skilled in the art that modifications may be made to the invention as described without departing from the scope of the claims set out below.

## Claims

1. An optical coupler for a photonic integrated circuit comprising:

   a first channel waveguide configured to guide electromagnetic radiation comprising a first wavelength;
   a second channel waveguide configured to guide electromagnetic radiation comprising a second wavelength that is different to the first wavelength;
   a slab waveguide optically coupled to the first and second channel waveguides and configured to guide electromagnetic radiation comprising both the first and second wavelengths;
   a computer generated waveguide hologram optically coupled to the slab waveguide; and,
   a metasurface optically coupled to the computer generated waveguide hologram.

2. The optical coupler of claim 1, wherein at least one of the first channel waveguide and the second channel waveguide comprises an adiabatic waveguide taper that is optically coupled to the slab waveguide.

3. The optical coupler of claim 1 or claim 2, wherein the computer generated waveguide hologram comprises an arrangement of unit cells, wherein each unit cell comprises a structure configured to introduce a phase shift to incident electromagnetic radiation, wherein a distance between the structures of two neighboring unit cells varies across at least part of the arrangement of unit cells.

4. The optical coupler of claim 3, wherein a size of the structure within each unit cell varies across at least part of the arrangement of unit cells.

5. The optical coupler of any preceding claim, wherein the metasurface comprises an arrangement of metasurface structures configured to introduce a phase shift to incident electromagnetic radiation, and wherein a form of the metasurface structures varies across at least part of the arrangement of metasurface structures.

6. An optical coupler for a photonic integrated circuit comprising:

   a first region configured to couple a first wavelength of electromagnetic radiation;
   a second region configured to couple a second wavelength of electromagnetic radiation that is different to the first wavelength of electromagnetic radiation; and,
   an intermediate region located between the first and second regions and configured to couple both the first and second wavelengths of electromagnetic radiation.

7. The optical coupler of claim 6, wherein the first region comprises a first computer generated waveguide hologram, the second region comprises a second computer generated waveguide hologram, and the intermediate region comprises both the first and second computer generated waveguide holograms.

8. A photonic integrated circuit comprising:

   a first optical coupler in accordance with any of claims 1 to 5; and,
   a second optical coupler in accordance with claim 6 or claim 7.

9. The photonic integrated circuit of claim 8, wherein the photonic integrated circuit is monolithic.

10. An optical metrology system comprising the photonic integrated circuit of claim 8 or claim 9.

11. The optical metrology system of claim 10, wherein the first optical coupler is configured to emit electromagnetic radiation comprising the first and second wavelengths at a target mark, and wherein the second optical coupler is configured to receive diffracted electromagnetic radiation from the target mark.

12. The optical metrology system of claim 10 or claim 11, comprising a plurality photonic integrated circuits in accordance with claim 8 or claim 9, wherein at least two of the photonic integrated circuits are configured to simultaneously emit electromagnetic radiation to, and receive diffracted electromagnetic radiation from, two separated target marks.

13. A lithographic apparatus comprising the optical metrology system of any of claims 10 to 12.

14. A method of optically measuring a target mark comprising:

> using the optical coupler of any of claims 1 to 5 to emit electromagnetic radiation comprising the first and second wavelengths at the target mark; and,
> using the optical coupler of claim 6 or claim 7 to receive diffracted electromagnetic radiation from the target mark.

15. A method of optically measuring first and second separated target marks comprising:

> using a first photonic integrated circuit in accordance with claim 8 or claim 9 to optically measure the first target mark; and,
> using a second photonic integrated circuit in accordance with claim 8 or claim 9 to optically measure the second target mark,
> wherein the first optical coupler of the first and second photonic integrated circuits are configured to emit electromagnetic radiation comprising the first and second wavelengths at the first and second target marks, and wherein the second optical coupler of the first and second photonic integrated circuits are configured to receive diffracted electromagnetic radiation from the first and second target marks.

FIG. 1

FIG. 2

FIG. 3

FIG. 4

FIG. 5

FIG. 6

EP 4 764 700 A1

FIG. 7

FIG. 8

FIG. 9

FIG. 10

EP 4 764 700 A1

EP 4 764 700 A1

700

600       600       600

-1   +1     -1   +1     -1   +1

$X_0$        $X_1$        $X_2$

$\longrightarrow X$

W

FIG. 11

## EUROPEAN SEARCH REPORT

Europäisches Patentamt
European Patent Office
Office européen des brevets

**Application Number**

EP 24 22 1971

### DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2016/202423 A1 (LI CHAO [SG] ET AL) 14 July 2016 (2016-07-14) | 6 | INV. G03F7/00 G02B6/12 |
| A | * abstract * * figures 2A,2B * * paragraphs [0002], [0066] - [0077] * | 1-5,7-15 | |
| A | US 2023/367144 A1 (YU NANFANG [US] ET AL) 16 November 2023 (2023-11-16) * abstract * * figure 1 * * paragraphs [0002], [0040] - [0054] * | 1-15 | |
| A | US 2009/290837 A1 (CHEN XIA [CN] ET AL) 26 November 2009 (2009-11-26) * abstract * * figure 1 * * paragraphs [0002], [0021] - [0039] * | 1-15 | |
| A | DISCLOSED ANONYMOUSLY: "RADIATION COUPLING SYSTEM", RESEARCH DISCLOSURE JOURNAL, QUESTEL , vol. 729, no. 100 12 December 2024 (2024-12-12), XP007153687, ISSN: 0374-4353 Retrieved from the Internet: URL:https://www.researchdisclosure.com/database/RD729100 [retrieved on 2024-12-12] * abstract * * figures 7,8 * * paragraphs [0001], [0049] - [0071] * | 1-15 | TECHNICAL FIELDS SEARCHED (IPC) G03F G02B |

The present search report has been drawn up for all claims

| Place of search | Date of completion of the search | Examiner |
|---|---|---|
| Munich | 13 June 2025 | Andersen, Ole |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## ANNEX TO THE EUROPEAN SEARCH REPORT
## ON EUROPEAN PATENT APPLICATION NO.

**EP 24 22 1971**

This annex lists the patent family members relating to the patent documents cited in the above-mentioned European search report.
The members are as contained in the European Patent Office EDP file on
The European Patent Office is in no way liable for these particulars which are merely given for the purpose of information.

**13-06-2025**

| Patent document cited in search report | Publication date | Patent family member(s) | Publication date |
|---|---|---|---|
| US 2016202423 A1 | 14-07-2016 | SG 11201601260P A<br>US 2016202423 A1<br>WO 2015047193 A1 | 30-03-2016<br>14-07-2016<br>02-04-2015 |
| US 2023367144 A1 | 16-11-2023 | NONE | |
| US 2009290837 A1 | 26-11-2009 | NONE | |

EPO FORM P0459

For more details about this annex : see Official Journal of the European Patent Office, No. 12/82